# EUROPÄISCHE PATENTSCHRIFT

(11) **EP 1 322 801 B1**
(45) Veröffentlichungstag und Bekanntmachung des Hinweises auf die Patenterteilung: **06.01.2010**
(21) Anmeldenummer: 01962856.9
(22) Anmeldetag: 14.07.2001
(51) Int. Cl.: C30B 25/14, C23C 16/455

(54) **CVD-VERFAHREN UND GASEINLASSORGAN ZUR DURCHFÜHRUNG DES VERFAHRENS**
CVD-METHOD AND GAS INLET MECHANISM FOR CARRYING OUT THE METHOD
PROCEDE CVD ET ORGANE D'ADMISSION DE GAZ POUR METTRE EN OEUVRE LE PROCEDE

(30) Priorität: 22.09.2000 DE 10061671; 23.12.2000 DE 10064941
(43) Veröffentlichungstag der Anmeldung: 02.07.2003
(73) Patentinhaber: AIXTRON AG, 52134 Herzogenrath (DE)
(72) Erfinder: STRAUCH, Gerd, 52072 Aachen (DE); KÄPPELER, Johannes, 52146 Würselen (DE); DAUELSBERG, Martin, 52064 Aachen (DE)
(74) Vertreter: Grundmann, Dirk
(86) Internationale Anmeldenummer: PCT/EP2001/008139
(87) Internationale Veröffentlichungsnummer: WO 2002/024985

(56) Entgegenhaltungen:
- EP-A- 0 334 432
- EP-A- 0 334 433
- WO-A-98/45501
- GB-A- 1 056 430
- US-A- 5 954 881
- FRIJLINK P M: "A NEW VERSATILE, LARGE SIZE MOVPE REACTOR" JOURNAL OF CRYSTAL GROWTH, NORTH-HOLLAND PUBLISHING CO. AMSTERDAM, NL, Bd. 93, Nr. 1 - 4, 1. November 1988 (1988-11-01), Seiten 207-215, XP000034974 ISSN: 0022-0248
- FRIJLINK P M ET AL: "LAYER UNIFORMITY IN A MULTIWAFER MOVPE REACTOR FOR III-V COMPOUNDS" JOURNAL OF CRYSTAL GROWTH, NORTH-HOLLAND PUBLISHING CO. AMSTERDAM, NL, Bd. 107, Nr. 1 / 4, 1991, Seiten 166-174, XP000246591 ISSN: 0022-0248
- BECCARD R ET AL: "A novel reactor concept for multiwafer growth of III-V semiconductors" JOURNAL OF CRYSTAL GROWTH, NORTH-HOLLAND PUBLISHING CO. AMSTERDAM, NL, Bd. 198-199, März 1999 (1999-03), Seiten 1049-1055, XP004171007 ISSN: 0022-0248

## Beschreibung

Die Erfindung betrifft ein Verfahren gemäß Gattungsbegriff des Anspruchs 1 und eine Vorrichtung gemäß Gattungsbegriff des Anspruchs 5.

Ein Verfahren bzw. eine derartige Vorrichtung wird in dem Artikel "A New Versatile, Large Size MOVPE Reactor", Journal of Chrystal Growth 93 (1988) 207-215, beschrieben. Um ein Gaseinlassorgan sind auf dem von unten insbesondere mittels Hochfrequenz beheizten Suszeptor planetenartig Substrate angeordnet, welche mit den Zerfallsprodukten der durch das Gaseinlassorgan eingebrachten Reaktionsgase beschichtet werden. Die Prozesskammer besitzt im Bereich des Gaseinlassorgancs bzw. den unmittelbar in Radialauswärtsrichtung daran angrenzenden Bereich eine Einlasszone, in welcher die gasförmigen Ausgangsstoffe zerfallen. In Radialauswärtsrichtung schließt sich an diese Einlasszone eine Depositionszone an, innerhalb welcher die Zerfallsprodukte hin zum Substrat diffundieren, um dort zu einer einkristallinen Schicht zu kondensieren.

Bei der bekannten Vorrichtung tritt das zweite Prozessgas durch die periphere Zuleitung axial in das Zentrum der Prozesskammer. Als zweites Prozessgas wird beispielsweise TMC oder TMI zusammen mit einem Trägergas beispielsweise Wasserstoff verwendet. Das Gas tritt gegen eine von der im Wesentlichen glockenförmig verlaufenden Rückwand der Vorkammer gebildeten Prallwand. Durch die zentrale Zuleitung treten zusammen mit einem Trägergas die MetallHydride, bspw. Phosphin oder Arsen, in die Prozesskammer ein. Die zentrale Öffnung ist nahe dem beheizten Suszeptor angeordnet. Dieses dort austretende Prozessgas strömt durch einen Spalt zwischen der Oberfläche des beheizten Suszeptors und der Stirnfläche des freien Endes des Gaseinlassorganes. Zufolge der Temperaturstrahlung des beheizten Suszeptors kann sich die Stirnfläche des Caseinlassorgancs aufheizen. Einhergehend damit heizt sich der gesamte Quarz-Körper, der den in die Prozesskammer ragenden Abschnitt des Gascinlassorganes ausbildet, auf. Dabei kann insbesondere der dem freien Ende des Gaseinlassorganes zugeordnete Abschnitt Temperaturen erreichen, bei welchen die durch die periphere Leitung zugeführten metallorganischen Verbindungen von Gallium oder Indium zerlegt werden, so dass in diesem Bereich der Vorkammer bzw. am Gasauslassring eine Deposition von Galliumarsenid oder Indiumphosphid auftritt. Diese parasitären Depositionen sind nachteilhaft.

Werden Galliumarsenid bzw. Indiumphosphid auf heißen Oberflächen deponiert, kann es bei einem zu kalten äußeren Umfangsabschnitt der die zentrale Zuleitung umgebenden Stirnfläche dort zu Phosphor- oder Arsenkondensationen kommen. Auch dies ist nachteilhaft.

Im Artikel "Layer Uniformity in a Multiwafer MOVPE Reactor for III-V Compounds", Journal of Crystal Growth (1991) 166-174, wird eine ähnliche Vorrichtung beschrieben.

Der Erfindung liegt die Aufgabe zugrunde, Maßnahme vorzuschlagen, um einerseits einer parasitären Deposition im Bereich der peripheren Austrittsöffnung und andererseits einer Kondensation der durch die zentrale Austrittsöffnung austretenden V-Komponente am radial äußeren Umfangsabschnitt der Stirnfläche des Gasauslassorganes entgegen zu wirken.

Gelöst wird die Aufgabe durch die in den Ansprüchen angegebene Erfindung. Der Anspruch 1 schlägt vor, dass zufolge einer Kegelstumpf- oder Rotationshyperboloid-Form einer von der Vurkammerrückwand gebildeten GasLeitfläche der dem Suszeptor zugewandte Endabschnitt des Gasauslassringes bzw. der radial äußere Abschnitt der die zentrale Austrittsöffnung umgebenden Stirnseite des Gasauslassorganes vom zweiten Prozesses gekühlt wird. Dabei wird der aus der zweiten Zuleitung der Prozesskammer zuzuführende Gasstrom von der Gasleitfläche derart umgelenkt, dass er sich an der durch die Strahlung des Suszeptors aufgeheizten Rückwand des in die Prozesskammer ragenden Abschnittes des Gaseinlassorganes erwärmt. Die dabei abgeführte Wärme kühlt den suszeptornahen Abschnitt der Vorkammer bzw. des Gasauslassringes. Dabei kann die Form der Gasleitfläche so gewählt werden, dass die Kühlung nur in dem Maße auftritt, dass die Temperatur im Endabschnitt des Gaseinlassorganes in einem Temperaturfenster gehalten wird, welches nach unten begrenzt ist durch die Depositionstemperatur der V-Komponente und nach oben durch die Depositionstemperatur der III-V-Verbindung. Der Druck in der Vorkammer wird zufolge eines porösen Gasauslassringes größer gehalten, als der Prozesskammerdruck. Die Verwendung eines porösen Gasauslassrings hat zudem gegenüber dem kammartigen Gasauslassring den Vorteil, dass sich hinter den Kammzinken keine Wirbel bilden, die einer parasitären Deposition förderlich sind. Besteht das Gasauslassorgan bspw. aus einer Quarz-Fritte, so tritt das Prozessgas homogenisiert aus dem Gasauslassring aus, wobei das Strömungsmaximum des Strömungsprofils außermittig liegt und zwar versetzt hin zum freien Ende des Gaseinlassorganes. Der Krümmungsradius der im Längsschnitt konkaven Leitfläche ist an die Strömungsparameter angepasst. Bei höheren Volumensströmen wird der Krümmungsradius größer gewählt als bei kleineren Volumensströmen. Die Längsschnittskontur der Gasleitfläche kann dann insbesondere eine Gerade sein, so dass die Gasleitfläche insgesamt eine Kegelstumpfform bekommt. Um die Gasleitflächenkontur den verschiedenen Prozessparametern wie Temperatur und Gesamtströmungsvolumen anpassen zu können, ist erfindungsgemäß vorgesehen, dass der in die Prozesskammer ragende Abschnitt des Gaseinlassorgans als Auswechselteil ausgebildet ist. Dieses kann mit der Zuleitung verschraubt werden. Es handelt sich dabei bevorzugt um ein Quarz-Teil, welches auch Träger des Gasauslassringes ist. Der Gasauslassring besitzt eine von der Vorkammerrückwand gebildete kegelstumpfförmig oder rotationshyperboloid-förmig gestaltete Gasleitfläche, die sich stufenfrei an die Zuleitung anschließt. Durch den an der Gasleitfläche laminar entlangströmenden Gasstrom wird eine konvektive Kühlung erzielt. Durch den im suszeptornahen Bereich erhöhten Austrittsstrom aus dem Gasauslassring wird zudem ein Spüleffekt erzielt. Bei einem Galliumarsenid-Abscheidungsprozess wird die Temperatur des suszeptornahen Abschnittes des Gaseinlassorgans in einem Temperaturfenster zwischen etwa 200°C und etwa 400°C gehalten.

Ausführungsbeispiele der Erfindungen werden nachfolgend anhand beigefügter Zeichnungen erläutert. Es zeigen:
- Fig. 1: ein erstes Ausführungsbeispiel eines Gaseinlassorganes,
- Fig. 2: einen Schnitt gemäß der Linie II-II,
- Fig. 3: einen Schnitt gemäß der Linie III-III,
- Fig. 4: einen Schnitt gemäß der Linie IV-IV,
- Fig. 5: ein zweites Ausführungsbeispiel gemäß Fig. 1 und
- Figuren 6-9: einen Umrüstsatz mit verschieden gestalteten Auswechselteilen.

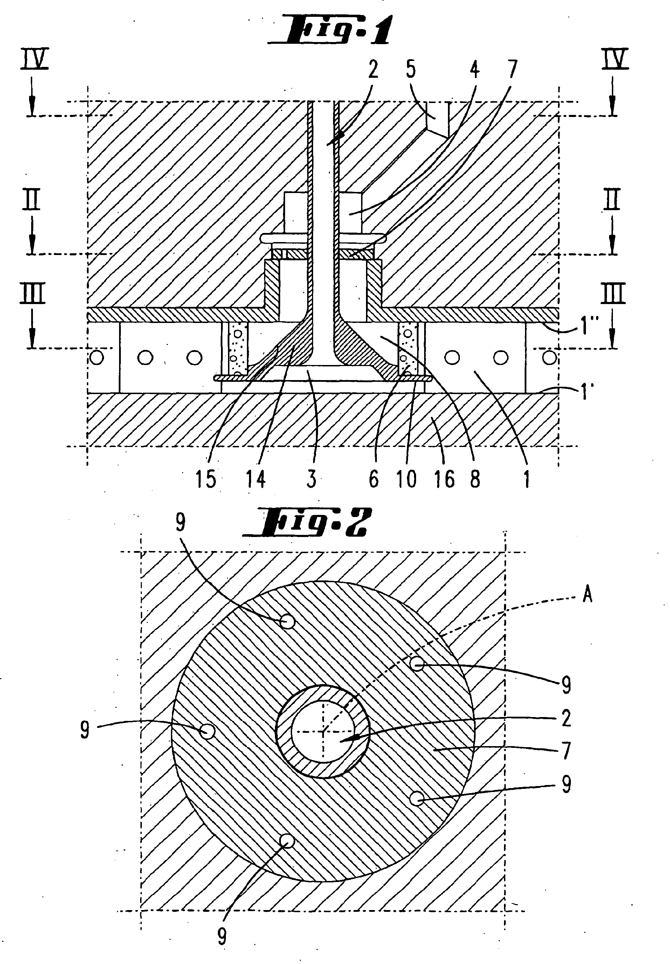

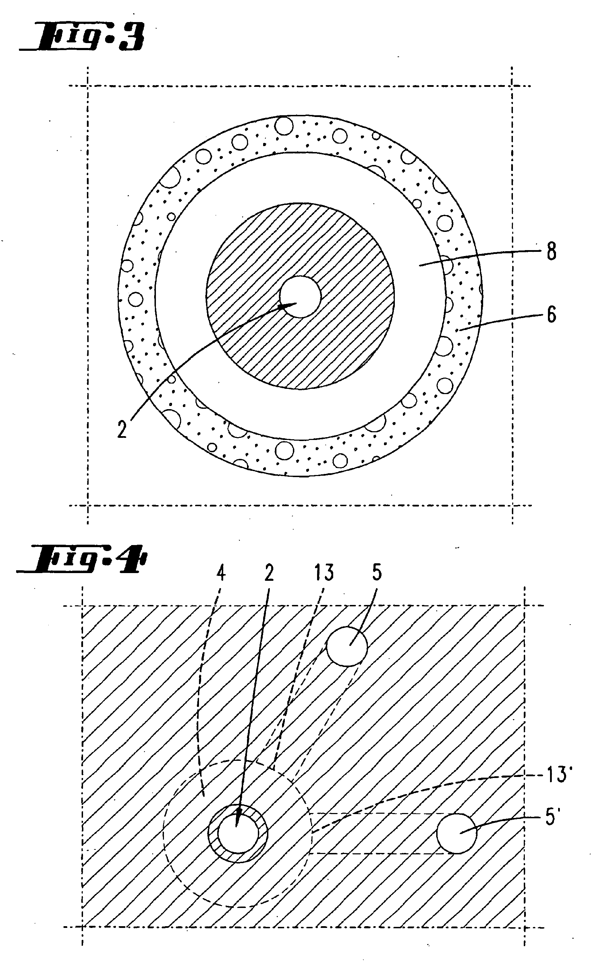

Das Ausführungsbeipiel gemäß den Figuren 1 bis 5 stellt einen Ausschnitt aus einem MOCVD-Reaktor dar. Die Prozesskammer trägt die Bezugsziffer 1. Sie besitzt einen Boden 1' und Decke 1". Der Boden 1' ist die Oberfläche eines von unten mittels Hochfrequenz beheizten Suszeptors 16, welcher aus Graphit besteht. Im Zentrum der zylindersymmetrischen Prozesskammer 1 befindet sich das Gaseinlassorgan. Dieses besitzt eine zentrale Zuleitung 2, welche in eine zentrale Austrittsöffnung 3 mündet. Diese zentrale Austrittsöffnung liegt in einer Stirnseitenkammer des Gaseinlassorganes. Die Stirnseite ist einem Quarz-Körper 14 zugeordnet. Dieser besitzt eine kegelstumpfförmige Wandung, die eine Gasleitfläche 15 ausbildet für das aus einer peripheren Zuleitung 4 axial ausströmende Gas. Das aus der peripheren Zuleitung 4 ausströmende Gas strömt in eine zwischen Prozesskammerdecke 1" und Prozesskammerboden 1' angeordnete ringförmige Vorkammer 8, deren Rückwand von der Gasleitfläche 15 gebildet ist.

Die ringförmige Vorkammer 8 wird von einem porösen Gasauslassring 6, welcher als Quarz-Fritte gefertigt ist, umgeben. Durch diesen Gasauslassring kann das durch die periphere Leitung 4 einströmende zweite Prozessgas in einem homogenisierten Strömungsprofil austreten.

Der Vorkammer 8 ist eine Ringdrossel 7 mit einer Vielzahl von Durchtrittsöffnungen 9 vorgeordnet. Der Ringdrossel 7 wiederum ist eine Mischkammer vorgeordnet, in welche zwei Gaszuleitungen 5, 5' an den mit den Bezugsziffern 13 bzw. 13' bezeichneten Stellen münden.

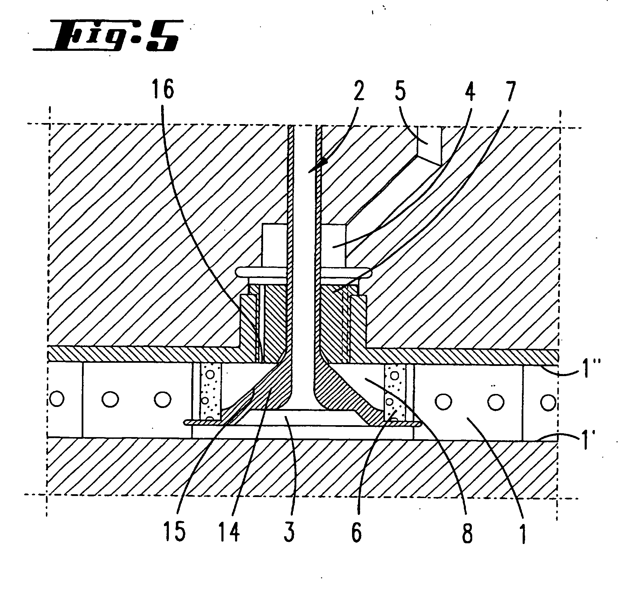

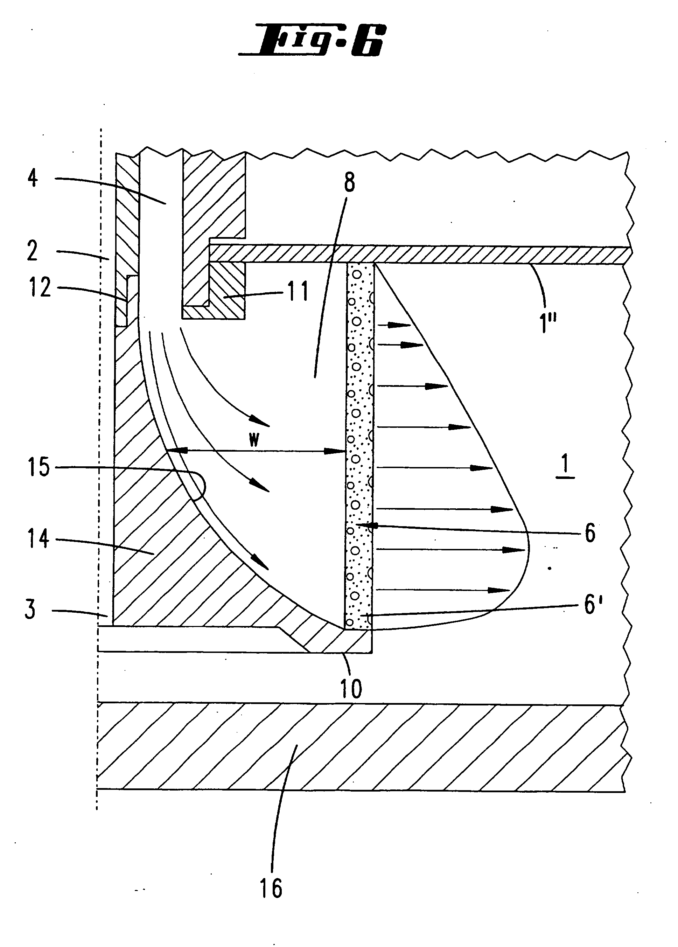

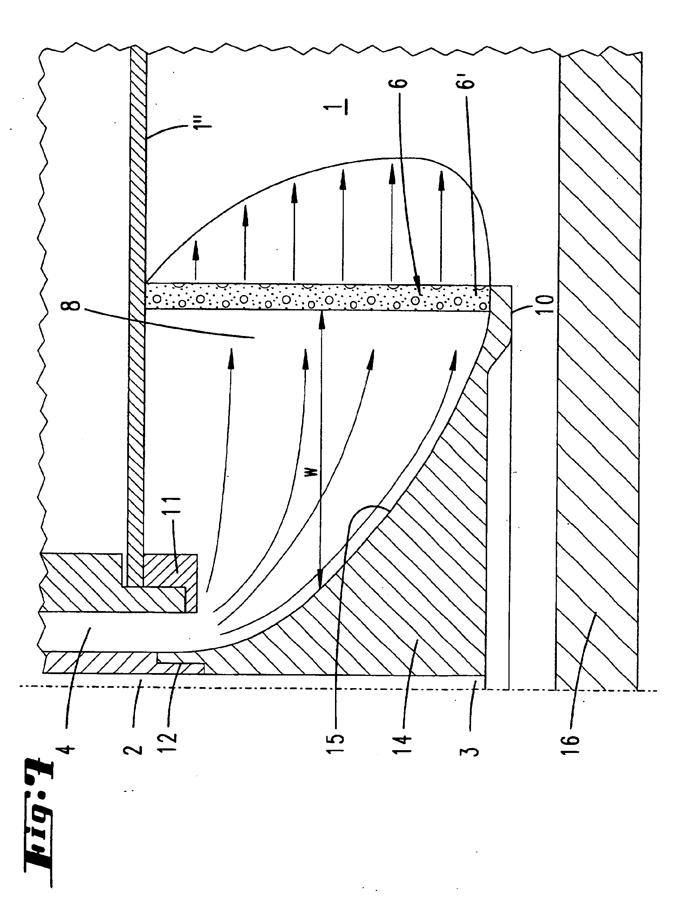

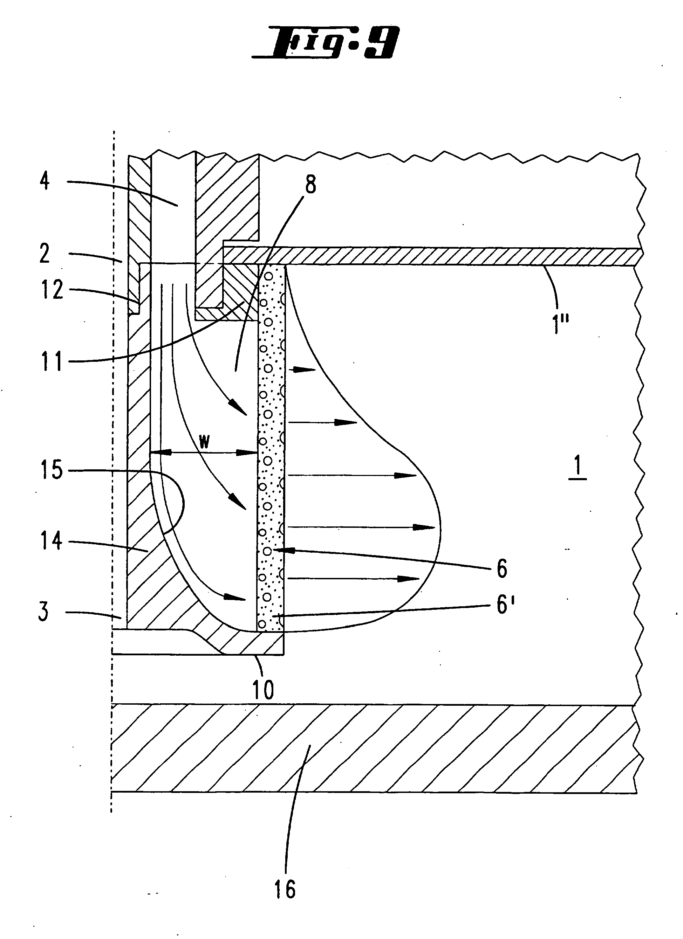

Die in Fig. 5 dargestellte Ringdrossel 7 hat zufolge ihrer vergrößerten Dicke eine höher Drosselfunktion. Die in den Figuren 6 bis 9 dargestellten Auswechselteile 14 können mittels einer Schraubverbindung 12 mit dem oberen Teil des Gaseinlassorganes, welches die zentrale Zuleitung 2 und die periphere Zuleitung 4 ausbildet, verschraubt werden. Mit diesem oberen Abschnitt ist auch eine Mutter 11 verschraubt, die eine Platte trägt, welche die Prozesskammerdecke 1' bildet. Der untere Abschnitt 6' des Gasauslassringes 6 ruht auf einem dünnwandigen radialen Ringvorsprung, der von dem Randabschnitt 10 des Auswechselteiles 14 gebildet ist. Oben stützt sich der Gasauslassring 6 an der besagten Platte bzw. an der Prozesskammerdecke 1' ab.

Die einzelnen Auswechselteile 14 der Figuren 6 bis 9 unterscheiden sich im Wesentlichen durch ihren Durchmesser und durch die Form ihrer Leitflächen voneinander. Die Leitflächen 15 der Auswechselteile der Figuren 6, 7 und 9 haben im Wesentlichen die Form eines Rotationshyperboloiden. In der dargestellten Längsschnittebene hat die Konturlinie der Gasleitfläche 15 eine konkave Form, die sich sprungstellenfrei an die Wandung der peripheren in Achsrichtung verlaufende Leitung 4 anschließt, so dass sich entlang der Gasleitfläche 15 keine Wirbel bilden. Die außerhalb des Gasauslassringes 6 dargestellten Pfeile deuten das axiale Strömungsprofil an. Es ist zu erkennen, dass das Maximum dieses Profil dem suszeptornahen Ende 6' des Gasauslassringes näher liegt, als dem der Prozesskammerdecke 1' nahen Bereich des Gasauslassringes. Dies hat zur Folge, dass der suszeptornahe Bereich und damit auch der Randabschnitt 10 stärker konvektiv gekühlt wird. Die Weite W der Ringkammer 8 nimmt bei allen Ausführungsbeispielen in axialer Richtung von der Decke 1' zum Suszeptor 16 ab.

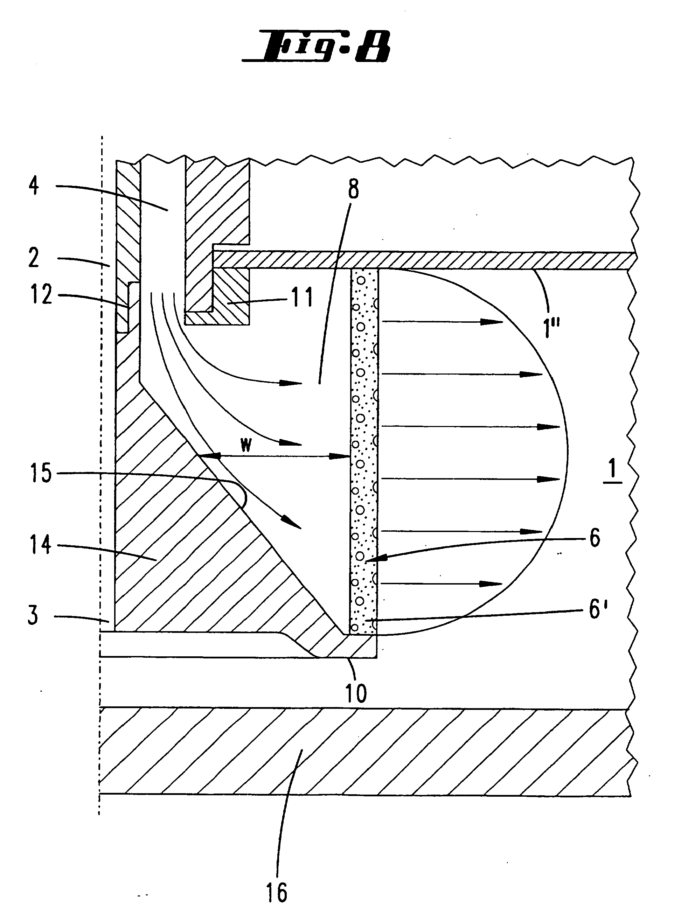

Bei dem in der Fig. 8 dargestellten Ausführungsbeispiel besitzt die Konturlinie der Gasleitfläche 15 des Längsschnittes die Form einer Geraden, so dass die Leitfläche 15 eine Kegelstumpfform besitzt. Diese Form wird bei großen Volumenströmen gewählt.

Der Suszeptor 16 ist von unten mittels einer nicht dargestellten Hochfrequenzheizung beheizt. Der Suszeptor 16 strahlt Wärme ab, die den Quarz-Körper 14 des Gasauslassorganes aufheizt. Durch die zentrale Austrittsöffnung 3 strömt das aus Arsen oder Phosphin und Wasserstoff bestehende erste Prozessgas. In dem Spalt zwischen dem Quarz-Körper 14 und der Oberfläche des Suszeptors 16 zerlegt sich das durch die Öffnung 3 heraustretende Arsen bzw. Phosphin. Die Zerlegungsprodukte werden in Radialrichtung weitertransportiert. Aus der peripheren Leitung 4 strömt TMG oder TMI zusammen mit Wasserstoff als zweites Prozessgas zunächst in die Vorkammer 8. Das aus der axialen Leitung 4 austretende Gas strömt laminar entlang der Leitfläche 15 und wird dabei um 90° umgelenkt. Es überströmt dabei den Randabschnitt 10. Da das aus der Leitung 4 strömende Gas nicht vorbeheizt ist, sondern im Wesentlichen Raumtemperatur besitzt, hat es gegenüber dem Quarz-Körper 14 eine kühlende Wirkung. Die Wärme wird dabei über die Leitfläche 15 aufgenommen. Insbesondere dort, wo die Materialstärke des Quarz-Teiles 14 am geringsten ist, nämlich im Bereich des Randabschnittes 10 entfaltet der Gasstrom seine größte Kühlwirkung. Dieser Bereich und insbesondere der dem Randabschnitt 10 benachbarte Gasauslassringabschnitt 6' werden deshalb vom Gasstrom am stärksten gekühlt. Die Prozesskammerdecke 1' ist unbeheizt. Demzufolge wäre der Bereich 6' des Gasauslassringes 6 ohne einen kühlenden Gasstrom am heißesten, da er dem heißen Suszeptor 16 am nächsten liegt. Zufolge der konvektiven Kühlung des aus der Leitung 4 tretenden Prozessgases wird der suszeptornahe Bereich 6' des Gasauslassringes 6 aber auf einer Temperatur gehalten, die im Wesentlichen der Temperatur des übrigen Bereiches des Gasauslassringes 6 entspricht. Diese Temperatur liegt höher, als die Kondensations-Temperatur des im Spalt zwischen dem Suszeptor 16 und dem Quarz-Körper 14 gebildeten Arsens oder Phosphors. Die Temperatur ist aber geringer, als die Depositionstemperatur der III-V-Verbindung.

Die Strömungsparameter sollen so eingestellt werden, dass der Gasauslassring über seine axiale Länge möglichst eine gleichbleibende Temperatur besitzt.

Die Anpassung des Verlaufs der Gasleitfläche 15 an die Prozessparameter erfolgt durch Austausch eines Auswechselteiles.

## Patentansprüche

1. Verfahren zum Abscheiden von insbesondere kristallinen Schichten auf insbesondere kristallinen Substraten, wobei zumindest zwei Prozessgase getrennt voneinander durch ein Gaseinlassorgan oberhalb eines beheizten Suszeptors (16) in eine Prozesskammer (1) eines Reaktors eingeleitet werden, wobei das erste Prozessgas durch eine zentrale Leitung (2) mit einer zentralen Austrittsöffnung (3) und das zweite Prozessgas durch eine dazu periphere Leitung (4) in eine ringförmige Vorkammer (8) strömt, die mit ihrer eine Kegelstumpf- oder Rotationshyperboloid-Form aufweisenden Rückwand (15) eine Casleitfläche bildet, und deren periphere Austrittsöffnung von einem die Vorkammer (8) umgebenden gasdurchlässigen Gasauslassring (6) gebildet wird, **dadurch gekennzeichnet, dass** der dem Suszeptor zugewandte Endabschnitt (6') des Gasauslassringes (6) bzw. der radial äußere Abschnitt der die zentrale Austrittsöffnung (3) umgebenden Stirnseite des Gasauslassorgans vom zweiten Prozessgas gekühlt wird, wobei der Druck in der Vorkammer (8) zufolge eines porösen Gasauslassringes (6) größer ist als in der Prozesskammer (1).

2. Verfahren nach Anspruch 1, **dadurch gekennzeichnet, dass** der Krümmungsradius der im Längsschnitt konkaven Leitfläche (15) bei höheren Volumen-Gasströmen größer gewählt ist.

3. Verfahren nach einem der vorhergehenden Ansprüche, **dadurch gekennzeichnen, dass** das Maximum des aus dem Gasauslassring (6) tretenden Gasstroms in der Längsschnittebene außermittig hin zum freien Ende (6') versetzt liegt.

4. Verfahren nach einem der vorhergehenden Ansprüche, **dadurch gekennzeichnet, dass** die Strömungsparameter und die Längsschnittkonturlinie der Gasleitfläche (16) derart aufeinander abgestimmt sind, dass die Temperatur des dem heißen Suszeptor (16) benachbarten Abschnittes des Gasauslassorganes größer ist als die Kondensationstemperatur des aus Phosphin oder Arsen pyrolytisch zerlegten Arsens bzw. Phosphors und niedriger ist als die Depositionstemperatur von Galliumarsenid oder Indiumphosphid.

5. Gaseinlassorgan für eine Vorrichtung zum Abscheiden von insbesondere kristallinen Schichten auf insbesondere kristallinen Substraten, mittels welchem zwei Prozessgase getrennt voneinander oberhalb eines beheizbaren Suszeptors (16) in eine Prozesskammer (1) eines Reaktors einleitbar sind, mit einer zentralen Leitung (2) mit zentraler stirnseitiger Austrittsöffnung (3) für das erste Prozessgas und mit einer dazu peripheren Leitung (4) mit peripherer Austrittsöffnung für das zweite Prozessgas, welche eine ringförmige Vorkammer (8) umgibt, deren radiale Weite (W) zufolge einer kegelstumpfförmigen oder rotationshyperboloidförmigen Rückwand (15) zum freien Ende (6') des rotationssymmetrischen Gasauslassorganes abnimmt, die eine Gasleitfläche (15) ausbildet, wobei die periphere Austrittsöffnung von einem die Vorkammer (8) umgebenden gasdurchlässigen Gasauslassring (6) gebildet ist, **dadurch gekennzeichnet, dass** der Gasauslassring (6) aus einem porösen Material besteht.

6. Gaseinlassorgan nach Anspruch 5, **dadurch gekennzeichnet, dass** der Gasauslassring (6) aus porösem Material besteht und insbesondere eine Quarz-Fritte ist.

7. Gaseinlassorgan nach Anspruch 5 oder 6, **dadurch gekennzeichnet, dass** die Gasleitfläche (15) einem Auswechselteil (14) zugeordnet ist.

8. Gaseinlassorgan nach Anspruch 6 oder 7, **dadurch gekennzeichnet, dass** sich die Gasleitfläche (15) stufenfrei der Zuleitung (4) anschließt.

9. Gaseinlassorgan nach Anspruch 7 oder 8, **dadurch gekennzeichnet, dass** das Auswechselteil (14) mit der Zuleitung (2, 4) verschraubbar oder im Wege eines Bajonettverschlusses verbindbar ist.

## Claims

1. Method for depositing, in particular, crystalline layers on, in particular, crystalline substrates, at least two process gases being introduced separately via a gas inlet member above a heated susceptor (16) into a process chamber (1) of a reactor, the first process gas flowing through a central line (2) having a central outlet opening (3), and the second process gas flowing through a line (4), which is peripheral with respect to said central line, into an annular antechamber (8) of which the rear wall (15), in the shape of a truncated cone or hyperboloid of revolution, forms a gas guidance surface and of which the peripheral outlet opening is formed by a gas-permeable gas discharge ring (6) which surrounds the antechamber (8), **characterised in that** the end portion (6') of the gas discharge ring (6) facing the susceptor and/or the radially outer portion of the end face of the gas discharge member surrounding the central outlet opening (3) is cooled by the second process gas, the pressure in the antechamber (8) being greater than in the process chamber (1) on account of a porous gas discharge ring (6).

2. Method according to claim 1, **characterised in that** the radius of curvature of the guidance surface (15), which is concave in longitudinal section, is selected to be larger for higher volumetric gas flows.

3. Method according to any one of the preceding claims, **characterised in that** the maximum of the gas flow emerging from the gas discharge ring (6), in the plane of the longitudinal section, is offset eccentrically towards the free end (6').

4. Method according to any one of the preceding claims, **characterised in that** the flow parameters and the outline of the longitudinal section of the gas guidance surface (16) are matched to one another in such a way that the temperature of the portion of the gas discharge member adjacent to the hot susceptor (16) is greater than the condensation temperature of the arsenic or phosphorus which is formed from phosphine or arsenic by pyrolytic decomposition, and is lower than the deposition temperature of gallium arsenide or indium phosphide.

5. Gas admission member for a device for depositing, in particular, crystalline layers on, in particular, crystalline substrates, by means of which member two process gases can be introduced separately above a heated susceptor (16) into a process chamber (1) of a reactor comprising a central line (2) having a central end-face outlet opening (3) for the first process gas and comprising a line (4) which is peripheral with respect to said central line and has a peripheral outlet opening for the second process gas, which opening surrounds an annular antechamber (8) of which the radial width (W) decreases towards the free end (6') of the rotationally symmetrical gas discharge member as a result of a rear wall (15) in the shape of a truncated cone or hyperboloid of revolution, said rear wall forming a gas guidance surface (15), the peripheral outlet opening being formed by a gas-permeable gas discharge ring (6) which surrounds the antechamber (8), **characterised in that** the gas discharge ring (6) consists of a porous material.

6. Gas admission member according to claim 5, **characterised in that** the gas discharge ring (6) consists of porous material and in particular is a quartz frit.

7. Gas admission member according to either claim 5 or claim 6, **characterised in that** the gas guidance surface (15) is associated with an exchangeable part (14).

8. Gas admission member according to either claim 6 or claim 7, **characterised in that** the gas guidance surface (15) connects to the feed line (4) without a step.

9. Gas admission member according to either claim 7 or claim 8, **characterised in that** the exchangeable part (14) can be screwed to the feed line (2, 4) or can be connected to the feed line (2, 4) by means of a bayonet connection.

## Revendications

1. Procédé de dépôt de couches, notamment cristallines, sur des substrats, notamment cristallins, au moins deux gaz de réaction étant introduits séparément l'un de l'autre dans une chambre de réaction (1) d'un réacteur par le biais d'un organe d'introduction de gaz situé au-dessus d'un suscepteur chauffé (6), le premier gaz de réaction et le deuxième gaz de réaction s'écoulant, respectivement dans un conduit central (2) possédant une ouverture de sortie centrale (3) et dans un conduit (4) périphérique au précédent, jusque dans une préchambre annulaire (8) qui forme, avec sa paroi arrière (15) en forme d'hyperboloïde de révolution ou de cône tronqué, une surface de guidage de gaz, et dont l'ouverture de sortie périphérique est formée par une bague de sortie de gaz (6) perméable aux gaz et entourant la préchambre (8), **caractérisé en ce**ci que la portion d'extrémité (6'), dirigée vers le suscepteur, de la bague de sortie de gaz (6) respectivement la portion radialement extérieure du côté frontal, entourant l'ouverture de sortie centrale (3), de l'organe de sortie de gaz est refroidie par le deuxième gaz de réaction, la pression dans la préchambre (8) étant supérieure à celle dans la chambre de réaction (1) à cause d'une bague de sortie de gaz poreuse (6).

2. Procédé selon la revendication 1, **caractérisé en ce**ci que le rayon de courbure de la surface de guidage (15), concave en coupe longitudinale, est choisi plus grand pour des débits volumétriques de gaz plus élevés.

3. Procédé selon l'une des revendications précédentes, **caractérisé en ce**ci que le maximum du débit de gaz sortant de la bague de sortie de gaz (6) est excentré dans le plan de coupe longitudinal en direction de l'extrémité libre (6').

4. Procédé selon l'une des revendications précédentes, **caractérisé en ce**ci que les paramètres d'écoulement et la ligne de contour, en coupe longitudinale, de la surface de guidage de gaz (16) sont adaptés l'un à l'autre de sorte que la température de la portion de l'organe de sortie de gaz qui est adjacente au suscepteur chaud (16) est supérieure à la température de condensation de l'arsenic ou du phosphore décomposé par voie pyrolytique de l'arsenic respectivement de la phosphine et inférieure à la température de dépôt de l'arséniure de gallium ou du phosphure d'indium.

5. Organe d'introduction de gaz pour dispositif de dépôt de couches, notamment cristallines, sur des substrats, notamment cristallins, au moyen duquel deux gaz de réaction peuvent être introduits séparément l'un de l'autre, au-dessus d'un suscepteur chauffé (6), dans une chambre de réaction (1) d'un réacteur, ledit organe d'introduction de gaz comportant un conduit central (2) possédant une ouverture de sortie frontale centrale (3) destinée au premier gaz de réaction et un conduit (4) périphérique au précédent et possédant une ouverture de sortie périphérique qui est destinée au deuxième gaz de réaction et qui entoure une préchambre annulaire dont la dimension radiale (W) diminue en direction de l'extrémité libre (6') de l'organe de sortie de gaz à symétrie de révolution en raison d'une paroi arrière (15) en forme d'hyperboloïde de révolution ou de cône tronqué qui forme une surface de guidage (15), l'ouverture de sortie périphérique étant formée par une bague de sortie de gaz (6) perméable aux gaz et entourant la préchambre (8), **caractérisé en ce**ci que la bague de sortie de gaz (6) est en un matériau poreux.

6. Organe d'introduction de gaz selon la revendication 5, **caractérisé en ce**ci que la bague de sortie de gaz (6) est en matériau poreux et est notamment une fritte de quartz.

7. Organe d'introduction de gaz selon la revendication 5 ou 6, **caractérisé en ce**ci que la surface de guidage de gaz (15) est associée à une pièce amovible (14).

8. Organe d'introduction de gaz selon la revendication 6 ou 7, **caractérisé en ce**ci que la surface de guidage de gaz (15) fait suite progressivement au conduit d'amenée (4).

9. Organe d'introduction de gaz selon la revendication 7 ou 8, **caractérisé en ce**ci que la pièce amovible (14) peut être vissée au conduit d'amenée (2, 4) ou raccordée à un joint à baïonnette.
